# EUROPÄISCHE PATENTSCHRIFT

(11) **EP 3 459 328 B1**
(45) Veröffentlichungstag und Bekanntmachung des Hinweises auf die Patenterteilung: **01.12.2021**
(21) Anmeldenummer: 16733525.6
(22) Anmeldetag: 29.06.2016
(51) Int. Cl.: H05K 7/14

(54) **STROMRICHTER**
POWER CONVERTER
CONVERTISSEUR DE PUISSANCE

(43) Veröffentlichungstag der Anmeldung: 27.03.2019
(73) Patentinhaber: Siemens Energy Global GmbH & Co. KG, 81739 München (DE)
(72) Erfinder: BÖHME, Daniel, 90480 Nürnberg (DE); KÜBEL, Thomas, 91056 Erlangen (DE); PIERSTORF, Steffen, 90443 Nürnberg (DE); SCHMITT, Daniel, 92353 Postbauer-Heng (DE); SCHREMMER, Frank, 90768 Fürth (DE); STOLTZE, Torsten, 91074 Herzogenaurach (DE); WAHLE, Marcus, 90587 Veitsbronn (DE)
(86) Internationale Anmeldenummer: PCT/EP2016/065191
(87) Internationale Veröffentlichungsnummer: WO 2018/001477

(56) Entgegenhaltungen:
- EP-A1- 2 458 726
- EP-A1- 2 905 889
- DE-U1-202014 004 749
- US-A1- 2013 322 016

## Beschreibung

Die Erfindung betrifft ein Modul eines modularen Multilevelstromrichters, das mindestens zwei elektronische Schaltelemente und einen elektrischen Energiespeicher aufweist. Ein derartiges Modul ist aus der internationalen Patentanmeldung WO 2012/113704 A2 bekannt.

Aus der Gebrauchsmusterschrift DE 20 2014 004 749 U1 ist eine elektronische Schaltung zum vereinfachten Betrieb von Mehrpunktumrichtern bekannt. Diese elektronische Schaltung weist mindestens zwei Module auf, die jeweils mindestens einen elektrischen Energiespeicher und mindestens einen elektronischen Schalter enthalten. Der elektronische Schalter ermöglicht das Wechseln einer elektrischen Verschaltung des mindestens einen elektrischen Energiespeichers mit den Energiespeichern anderer Module.

Aus der europäischen Patentanmeldung EP 2 905 889 A1 ist ein modularer Multilevelstromrichter bekannt, der eine Mehrzahl von elektrisch in Serie geschalteten Zellen aufweist. Dabei weist jede Zelle einen Kondensator und mindestens einen Bipolartransistor mit isolierter Gate-Elektrode auf.

Stromrichter sind leistungselektronische Schaltungen zum Umwandeln von elektrischer Energie. Mit Stromrichtern kann Wechselstrom in Gleichstrom, Gleichstrom in Wechselstrom, Wechselstrom in Wechselstrom anderer Frequenz und/oder Amplitude oder Gleichstrom in Gleichstrom anderer Spannung umgewandelt werden. Stromrichter können eine Vielzahl von gleichartigen Modulen (die auch als Submodule bezeichnet werden) aufweisen, welche elektrisch in Reihe geschaltet sind. Diese Module weisen jeweils mindestens zwei elektronische Schaltelemente und einen elektrischen Energiespeicher auf. Solche Stromrichter werden als modulare Multilevelstromrichter bezeichnet und gehören zu den VSC-Stromrichtern (VSC = voltage sourced converter). Durch die elektrische Reihenschaltung der Module lassen sich hohe Ausgangsspannungen erreichen. Die Stromrichter sind einfach an unterschiedliche Spannungen anpassbar (skalierbar) und eine gewünschte Ausgangsspannung kann relativ genau erzeugt werden. Modulare Multilevelstromrichter werden oftmals im Hochspannungsbereich eingesetzt, beispielsweise als Stromrichter bei Hochspannungs-Gleichstrom-Übertragungsanlagen oder als Blindleistungskompensatoren bei flexiblen Drehstromübertragungssystemen.

Bei Auftreten eines Defekts an einem Modul des Stromrichters, insbesondere bei Auftreten eines Kurzschlusses an einem Modul des Stromrichters, können sehr hohe Ströme (z.B. sehr hohe Kurzschlussströme) fließen. Dadurch können heiße ionisierte Gase (Plasma) entstehen. Durch ein solches heißes Plasma kann nicht nur das defekte Modul weiter beschädigt werden, sondern es können auch benachbarte intakte Module beschädigt werden. Es kann gewissermaßen zu einer Art Kettenreaktion kommen, bei der immer mehr Module beschädigt werden und ausfallen.

Der Erfindung liegt die Aufgabe zugrunde, ein Modul anzugeben, bei dem auch bei Auftreten eines Defekts an dem Modul eine Beschädigung benachbarter Module verringert oder vermieden wird.

Diese Aufgabe wird erfindungsgemäß gelöst durch ein Modul nach dem unabhängigen Patentanspruch. Vorteilhafte Ausführungsformen des Moduls sind in den abhängigen Patentansprüchen angegeben.

Offenbart wird ein Modul eines modularen Multilevelstromrichters (insbesondere für Hochspannungsanwendungen), das mindestens zwei elektronische Schaltelemente, einen elektrischen Energiespeicher und eine elektrische Litzenleitung aufweist, wobei die Litzenleitung eine metallische Litze und eine die Litze umgebende Isolierhülle aufweist, und wobei (an einem Ende der Litzenleitung) aus der Isolierhülle herausragende Litze mit einer Kapselung versehen ist. Bei diesem Modul ist also die aus der Isolierhülle herausragende Litze (mit anderen Worten: der aus der Isolierhülle herausragende Abschnitt der Litze) mit einer Kapselung versehen (gekapselt, umkapselt, eingekapselt). Die Kapselung schließt also die herausragende Litze ein. Die Kapselung stellt auch eine Abdeckung dar, welche die aus der Isolierhülle herausragende Litze abdeckt. Unter einer Kapselung wird insbesondere ein Einschließen der herausragenden Litze mit einem festen Material verstanden. Dabei ist das Material der Kapselung verschieden von dem Material der Litze.

Durch diese Kapselung wird vermieden, dass sich das bei einem Defekt des Moduls gegebenenfalls entstehende Plasma ungehindert ausbreiten kann. Vielmehr wird durch die Kapselung eine Ausbreitung des Plasmas behindert, wodurch sich das Plasma langsamer ausbreitet oder wodurch sich nur geringe Mengen des Plasmas ausbreiten können. Dadurch wird eine Beschädigung benachbarter Module zumindest verringert, wenn nicht sogar vollständig vermieden. Bei vergleichsweise kleinen Fehlerströmen kann durch die Kapselung sogar die Entstehung des Plasmas behindert werden, so dass weniger Plasma entsteht und sich ausbreiten kann.

Das Modul kann so ausgestaltet sein, dass die Kapselung eine elektrisch isolierende Kapselung ist. Durch die elektrisch isolierende Kapselung wird zusätzlich eine elektrische Isolierung der der aus der Isolierhülle herausragenden Litze erreicht.

Das Modul kann auch so ausgestaltet sein, dass die Kapselung die herausragende Litze umhüllt. Durch eine derartige die Litze umhüllende Kapselung wird die Entstehung oder Ausbreitung des Plasmas besonders effektiv behindert.

Das Modul kann auch so ausgestaltet sein, dass die Kapselung ein die herausragende Litze umgebendes Kapselungsgehäuse oder ein die herausragende Litze umgebendes Kapselungsmaterial aufweist. Die Kapselung kann also verschiedene Formen aufweisen.

Das Modul kann so ausgestaltet sein, dass das Kapselungsmaterial ein elektrisch isolierendes Vergussmaterial oder ein elektrisch isolierendes Spritzmaterial ist. Das Kapselungsmaterial kann also ein Vergussmaterial (wie beispielsweise Gießharz) oder ein Spritzmaterial (wie beispielsweise ein faserverstärkter Kunststoff, insbesondere ein faserverstärkter Kunststoff mit hoher Zähigkeit) sein.

Das Modul kann so ausgestaltet sein, dass das Kapselungsgehäuse die herausragende Litze und die zwei elektronischen Schaltelemente einkapselt. Vorteilhafterweise kapselt das Kapselgehäuse sowohl die aus der Isolierhülle herausragende Litze als auch die beiden elektronischen Schaltelemente des Moduls ein. Dadurch bietet das Kapselungsgehäuse zusätzlich einen Schutz vor einer Explosion der elektronischen Schaltelemente, welche bei einem Defekt des Moduls ebenfalls auftreten kann. Hierbei ist vorteilhaft, dass die elektronischen Schaltelemente und die aus der Isolierhülle herausragende Litze nicht mit jeweils einer eigenen Kapselung versehen sein müssen, sondern dass sich die elektronischen Schaltelemente und die herausragende Litze in einem gemeinsamen Kapselungsgehäuse befinden.

Das Modul kann auch so ausgestaltet sein, dass die Litzenleitung verbunden ist mit einem Spannungssensor zum Ermitteln der Spannung des Energiespeichers. Zum Übertragen der Sensorwerte des Spannungssensors können vorteilhafterweise eine Litzenleitung (oder zwei Litzenleitungen) eingesetzt sein. Im normalen Betriebsfall fließt über die mit dem Spannungssensor verbundene Litzenleitung nur ein sehr geringer Strom, so dass für diese Anwendung eine Litzenleitung (sogar eine Litzenleitung mit einem sehr geringen Durchmesser) ausreichend ist. Es hat sich jedoch herausgestellt, dass im Fehlerfall die hohen Kurzschlussströme auch über diese Litzenleitung fließen können, wodurch an dem aus der Isolierhülle herausragenden Ende der Litzenleitung das unerwünschte Plasma entstehen kann. Daher ist es besonders vorteilhaft, bei dieser mit dem Spannungssensor verbundenen Litzenleitung die aus der Isolierhülle herausragende Litze mit der Kapselung zu versehen, d.h. die herausragende Litze einzukapseln.

Das Modul kann so ausgestaltet sein, dass die Litzenleitung einen Spannungssensor zum Ermitteln der Spannung des Energiespeichers mit einer (modulinternen) Steuereinrichtung für das Modul verbindet.

Das Modul kann auch so ausgestaltet sein, dass der elektrische Energiespeicher ein Kondensator ist.

Das Modul kann so ausgestaltet sein, dass die zwei elektronischen Schaltelemente des Moduls in einer Halbbrückenschaltung angeordnet sind. Dabei bilden die zwei elektronischen Schaltelemente eine elektrische Reihenschaltung und der Energiespeicher ist elektrisch parallel zu der Reihenschaltung geschaltet. Ein derartiges Modul wird auch als Halbbrücken-Modul oder als Halbbrücken-Submodul bezeichnet.

Das Modul kann auch so ausgestaltet sein, dass das Modul die zwei elektronischen Schaltelemente und zwei weitere elektronische Schaltelemente aufweist, wobei die zwei elektronischen Schaltelemente und die zwei weiteren elektronischen Schaltelemente in einer Vollbrückenschaltung angeordnet sind. Ein derartiges Modul wird auch als Vollbrücken-Modul oder auch als Vollbrücken-Submodul bezeichnet.

Offenbart wird weiterhin ein modularer Multilevelstromrichter mit mindestens einem Modul, insbesondere mit einer Mehrzahl von Modulen, nach einer der vorstehend beschriebenen Varianten.

Offenbart werden auch eine Hochspannungs-Gleichstrom-Übertragungsanlage und eine Blindleistungs-Kompensationsanlage mit einem derartigen modularen Multilevelstromrichter.

Im Folgenden wird die Erfindung anhand von Ausführungsbeispielen näher erläutert. Gleiche Bezugszeichen verweisen dabei auf gleiche oder gleich wirkende Elemente. Dazu ist in
- Figur 1: ein Ausführungsbeispiel eines Stromrichters, der eine Vielzahl von Modulen aufweist, in
- Figur 2: ein Ausführungsbeispiel eines Moduls, in
- Figur 3: ein weiteres Ausführungsbeispiel eines Moduls, in
- Figur 4: ein Ausführungsbeispiel einer Litzenleitung mit einer Kapselung, in
- Figur 5: ein weiteres Ausführungsbeispiel einer Litzenleitung mit einer Kapselung, in
- Figur 6: ein drittes Ausführungsbeispiel einer Litzenleitung mit einer Kapselung, in
- Figur 7: ein Ausführungsbeispiel einer Hochspannungs-Gleichstrom-Übertragungsanlage und in
- Figur 8: ein Ausführungsbeispiel einer Blindleistungs-Kompensationsanlage
dargestellt.

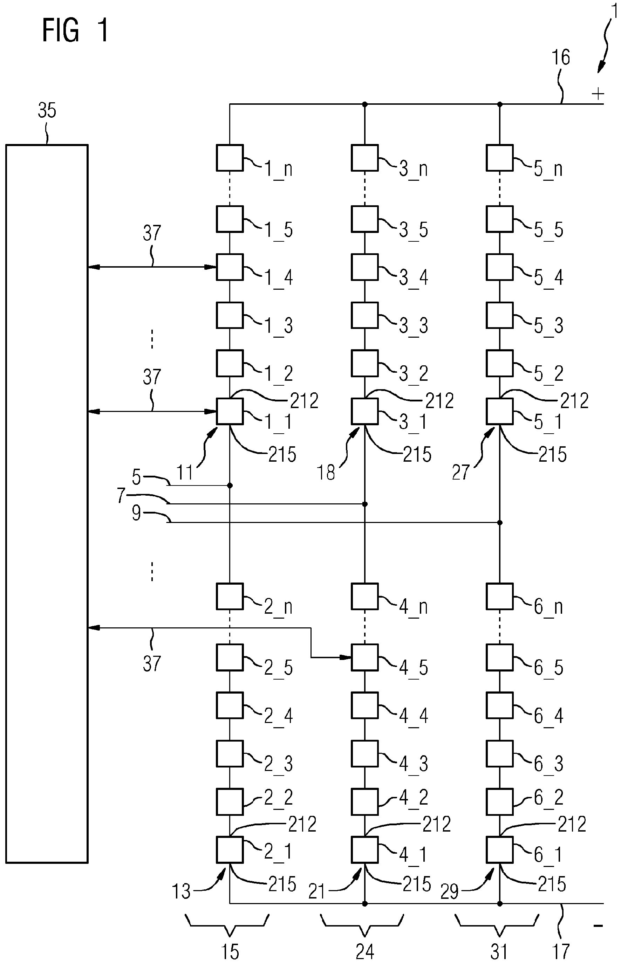

In Figur 1 ist ein Stromrichter 1 in Form eines modularen Multilevelstromrichters 1 (modular multilevel converter, MMC) dargestellt. Dieser Multilevelstromrichter 1 weist einen ersten Wechselspannungsanschluss 5, einen zweiten Wechselspannungsanschluss 7 und einen dritten Wechselspannungsanschluss 9 auf. Der erste Wechselspannungsanschluss 5 ist elektrisch mit einem ersten Phasenmodulzweig 11 und einem zweiten Phasenmodulzweig 13 verbunden. Der erste Phasenmodulzweig 11 und der zweite Phasenmodulzweig 13 bilden ein erstes Phasenmodul 15 des Stromrichters 1. Das dem ersten Wechselspannungsanschluss 5 abgewandte Ende des ersten Phasenmodulzweigs 11 ist mit einem ersten Gleichspannungsanschluss 16 elektrisch verbunden; das dem ersten Wechselspannungsanschluss 5 abgewandte Ende des zweiten Phasenmodulzweigs 13 ist mit einem zweiten Gleichspannungsanschluss 17 elektrisch verbunden. Der erste Gleichspannungsanschluss 16 ist ein positiver Gleichspannungsanschluss; der zweite Gleichspannungsanschluss 17 ist ein negativer Gleichspannungsanschluss.

Der zweite Wechselspannungsanschluss 7 ist mit einem Ende eines dritten Phasenmodulzweigs 18 und mit einem Ende eines vierten Phasenmodulzweigs 21 elektrisch verbunden. Der dritte Phasenmodulzweig 18 und der vierte Phasenmodulzweig 21 bilden ein zweites Phasenmodul 24. Der dritte Wechselspannungsanschluss 9 ist mit einem Ende eines fünften Phasenmodulzweigs 27 und mit einem Ende eines sechsten Phasenmodulzweigs 29 elektrisch verbunden. Der fünfte Phasenmodulzweig 27 und der sechste Phasenmodulzweig 29 bilden ein drittes Phasenmodul 31.

Das dem zweiten Wechselspannungsanschluss 7 abgewandte Ende des dritten Phasenmodulzweigs 18 und das dem dritten Wechselspannungsanschluss 9 abgewandte Ende des fünften Phasenmodulzweigs 27 sind mit dem ersten Gleichspannungsanschluss 16 elektrisch verbunden. Das dem zweiten Wechselspannungsanschluss 7 abgewandte Ende des vierten Phasenmodulzweigs 21 und das dem dritten Wechselspannungsanschluss 9 abgewandte Ende des sechsten Phasenmodulzweigs 29 sind mit dem zweiten Gleichspannungsanschluss 17 elektrisch verbunden.

Jeder Phasenmodulzweig weist eine Mehrzahl von Modulen (1_1, 1_2, 1_3, 1_4 ... 1_n; 2_1 ... 2_n; usw.) auf, welche (mittels ihrer galvanischen Stromanschlüsse) elektrisch in Reihe geschaltet sind. Solche Module werden auch als Submodule bezeichnet. Im Ausführungsbeispiel der Figur 1 weist jeder Phasenmodulzweig n Module auf. Die Anzahl der mittels ihrer galvanischen Stromanschlüsse elektrisch in Reihe geschalteten Module kann sehr verschieden sein, mindestens sind drei Module in Reihe geschaltet, es können aber auch beispielsweise 50, 100 oder mehr Module elektrisch in Reihe geschaltet sein. Im Ausführungsbeispiel ist n = 36: der erste Phasenmodulzweig 11 weist also 36 Module 1_1, 1_2, 1_3, ... 1_36 auf. Die anderen Phasenmodulzweige 13, 18, 21, 27 und 29 sind gleichartig aufgebaut.

Im linken Bereich der Figur 1 ist schematisch eine Steuereinrichtung 35 (Control-System 35) für die Module 1_1 bis 6_n dargestellt. Von dieser zentralen Steuereinrichtung 35 werden optische Nachrichten über eine optische Kommunikationsverbindung 37 (zum Beispiel über einen Lichtwellenleiter) zu den einzelnen Modulen übertragen. Die Nachrichtenübertragung zwischen der Steuereinrichtung und einem Modul ist jeweils symbolhaft durch eine Linie 37 dargestellt; die Richtung der Nachrichtenübertragung ist durch die Pfeilspitzen an den Linien 37 symbolisiert. Dies ist am Beispiel der Module 1_1, 1_4 und 4_5 dargestellt; zu den anderen Modulen werden auf die gleiche Art und Weise Nachrichten gesendet bzw. von diesen Modulen Nachrichten empfangen. Beispielsweise sendet die Steuereinrichtung 35 an die einzelnen Module jeweils einen Sollwert zur Höhe der Ausgangsspannung, die das jeweilige Modul bereitstellen soll.

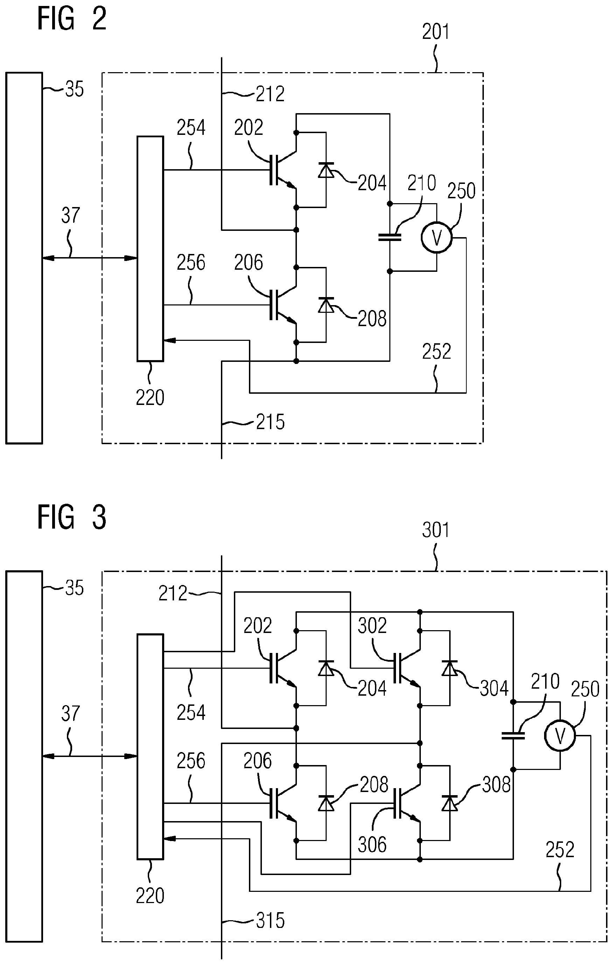

In Figur 2 ist beispielhaft der Aufbau eines Moduls 201 dargestellt. Dabei kann es sich beispielsweise um das Modul 1_1 des ersten Phasenmodulzweigs 11 (oder auch um eines der anderen in Figur 1 dargestellten Module) handeln. Das Modul ist als ein Halbbrückenmodul 201 ausgestaltet. Das Modul 201 weist ein erstes abschaltbares Halbleiterventil 202 mit einer ersten antiparallel geschalteten Diode 204 auf. Weiterhin weist das Modul 201 ein zweites abschaltbares Halbleiterventil 206 mit einer zweiten antiparallel geschalteten Diode 208 sowie einen elektrischen Energiespeicher 210 in Form eines Kondensators 210 auf. Das erste abschaltbare Halbleiterventil 202 ist ein erstes elektronisches Schaltelement 202; das zweite abschaltbare Halbleiterventil 206 ist ein zweites elektronisches Schaltelement 206. Das erste abschaltbare Halbleiterventil 202 und das zweite abschaltbare Halbleiterventil 206 sind jeweils als ein IGBT (insulated-gate bipolar transistor) ausgestaltet. Das erste abschaltbare Halbleiterventil 202 ist elektrisch in Reihe geschaltet mit dem zweiten abschaltbaren Halbleiterventil 206. Am Verbindungspunkt zwischen den beiden Halbleiterventilen 202 und 206 ist ein erster galvanischer Modulanschluss 212 angeordnet. An dem Anschluss des zweiten Halbleiterventils 206, welcher dem Verbindungspunkt gegenüberliegt, ist ein zweiter galvanischer Modulanschluss 215 angeordnet. Der zweite Modulanschluss 215 ist weiterhin mit einem ersten Anschluss des Energiespeichers 210 verbunden; ein zweiter Anschluss des Energiespeichers 210 ist elektrisch verbunden mit dem Anschluss des ersten Halbleiterventils 202, der dem Verbindungspunkt gegenüberliegt.

Der Energiespeicher 210 ist also elektrisch parallel geschaltet zu der Reihenschaltung aus dem ersten Halbleiterventil 202 und dem zweiten Halbleiterventil 206. Durch entsprechende Ansteuerung des ersten Halbleiterventils 202 und des zweiten Halbleiterventils 206 durch die modulinterne elektronische Modulsteuereinrichtung 220 kann erreicht werden, dass zwischen dem ersten galvanischen Modulanschluss 212 und dem zweiten galvanischen Modulanschluss 215 entweder die Spannung des Energiespeichers 210 ausgegeben wird oder keine Spannung ausgegeben wird (d.h. eine Nullspannung ausgegeben wird). Durch Zusammenwirken der Module der einzelnen Phasenmodulzweige kann so die jeweils gewünschte Ausgangsspannung des Stromrichters erzeugt werden.

Die Modul-Steuereinrichtung 220 kann Informationen über den aktuellen Zustand des Moduls (Statusinformationen) erfassen und (über die Kommunikationsverbindung 37) zu der zentralen Steuereinrichtung 35 übermitteln. Die Statusinformationen können beispielsweise Messwerte der Spannung des elektrischen Energiespeichers oder Informationen über die Schaltzustände der elektronischen Schaltelemente aufweisen.

Weiterhin weist das Modul 201 einen Spannungs-Messsensor 250 auf, dessen Spannungs-Messanschlüsse mit den zwei Polen des elektrischen Energiespeichers 210 elektrisch verbunden sind. Der Spannungs-Messsensor 250 ist also parallel zu dem elektrischen Energiespeicher 210 geschaltet. Der Spannungs-Messsensor 250 misst die an dem elektrischen Energiespeicher 210 auftretende Spannung und überträgt einen Messwert der Spannung des elektrischen Energiespeichers (Spannungsmesswert) über eine elektrische Messleitung 252 zu der Modul-Steuereinrichtung 220. Die elektrische Messleitung 252 ist im Ausführungsbeispiel als eine Litzenleitung 252 ausgestaltet.

Die elektrische Litzenleitung 252 ist also sowohl mit dem Spannungssensor 250 als auch mit der Modul-Steuereinrichtung 220 elektrisch verbunden. Mit anderen Worten verbindet die Litzenleitung 252 den Spannungssensor mit der Steuereinrichtung 220 und überträgt die Messwerte des Spannungssensors 250 zu der Steuereinrichtung 220. Über die Litzenleitung 252 fließen jedoch bei Normalbetrieb des Moduls 201 nicht die großen Ströme, die mittels der Schaltelemente 202 und 206 geschaltet werden, und die über die galvanischen Modulanschlüsse 212 und 215 fließen. Bei Normalbetrieb des Moduls 201 fließen über die Litzenleitung 252 nur sehr geringe Ströme, so dass eine Litzenleitung mit einem geringen Leitungsdurchmesser ausreichend ist. Die Litzenleitung 252 dient also zur Signalübertragung innerhalb des Moduls 201. Es handelt sich also um eine Signalübertragungs-Litzenleitung 252.

Es hat sich jedoch herausgestellt, dass bei Auftreten eines Fehlers an dem Modul große Fehlerströme (z. B. Kurzschlussströme) über diese Litzenleitung 252 fließen können, wodurch ein Plasma entsteht, dass auch örtlich zu dem Modul 201 benachbarte Module beschädigen kann. Auch andere Leitungen in dem Modul 201 können als Litzenleitungen ausgestaltet sein, zum Beispiel eine elektrische Leitung 254 zwischen der Modul-Steuereinrichtung 220 und dem ersten elektronischen Schaltelement 202 und/oder eine elektrische Leitung 256 zwischen der Modul-Steuereinrichtung 220 und dem zweiten elektronischen Schaltelement 206.

In Figur 3 ist ein weiteres Ausführungsbeispiel eines Moduls 301 des modularen Multilevel-Stromrichters 1 dargestellt. Bei diesem Modul 301 kann es sich beispielsweise um das Modul 1_2 (oder auch um eines der anderen in Figur 1 dargestellten Module) handeln. Neben dem bereits aus Figur 2 bekannten ersten Halbleiterventil 202, zweiten Halbleiterventil 206, erster Diode 204, zweiter Diode 208 und Energiespeicher 210 weist das in Figur 3 dargestellte Modul 301 ein drittes abschaltbares Halbleiterventil 302 mit einer antiparallel geschalteten dritten Diode 304 sowie ein viertes abschaltbares Halbleiterventil 306 mit einer antiparallel geschalteten vierten Diode 308 auf. Das dritte abschaltbare Halbleiterventil 302 ist ein drittes elektronisches Schaltelement 302; das vierte abschaltbare Halbleiterventil 306 ist ein viertes elektronisches Schaltelement 306. Das dritte abschaltbare Halbleiterventil 302 und das vierte abschaltbare Halbleiterventil 306 sind jeweils als ein IGBT ausgestaltet. Im Unterschied zur Schaltung der Figur 2 ist der zweite galvanische Modulanschluss 315 nicht mit dem zweiten Halbleiterventil 206 elektrisch verbunden, sondern mit einem Mittelpunkt einer elektrischen Reihenschaltung aus dem dritten Halbleiterventil 302 und dem vierten Halbleiterventil 306.

Das Modul 301 der Figur 3 ist ein sogenanntes Vollbrücken-Modul 301. Dieses Vollbrücken-Modul 301 zeichnet sich dadurch aus, dass bei entsprechender Ansteuerung der vier Halbleiterventile zwischen dem ersten galvanischen Modulanschluss 212 und dem zweiten galvanischen Modulanschluss 315 wahlweise entweder die positive Spannung des Energiespeichers 210, die negative Spannung des Energiespeichers 210 oder eine Spannung des Wertes Null (Nullspannung) ausgegeben werden kann. Somit kann also mittels des Vollbrückenmoduls 301 die Polarität der Ausgangsspannung umgekehrt werden. Der Stromrichter 1 kann entweder nur Halbbrücken-Module 201, nur Vollbrücken-Module 301 oder auch Halbbrücken-Module 201 und Vollbrücken-Module 301 aufweisen. Über den ersten galvanischen Modulanschluss 212 und den zweiten galvanischen Modulanschluss 215, 315 fließen große elektrische Ströme des Stromrichters.

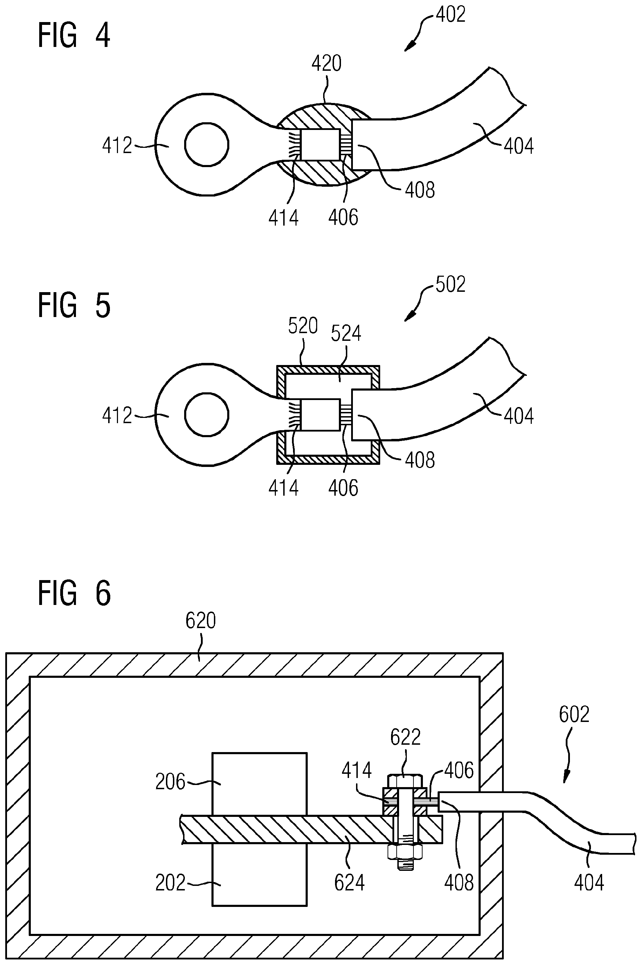

In Figur 4 ist in einer teilweisen Schnittdarstellung ein Ausführungsbeispiel einer Litzenleitung 402 dargestellt, bei der es sich beispielsweise um die Litzenleitung 252 der Figuren 2 und 3 handeln kann. Diese Litzenleitung 402 weist eine elektrisch isolierende Isolierhülle 404 sowie eine im inneren der Isolierhülle 404 verlaufende Litze auf. (Als "Litze" werden die dünnen Einzeldrähte einer elektrischen Leitung bezeichnet, wobei die Leitung aufgrund der Vielzahl der dünnen Einzeldrähte leicht zu biegen (flexibel) ist.)

An einem Ende 408 der Isolierhülle 404 (das gleichzeitig ein Ende 408 der Litzenleitung 402 darstellt) tritt die Litze 406 aus der Isolierhülle 404 heraus. Mit anderen Worten ragt die Litze 406 aus der Isolierhülle 404 heraus. Die aus der Isolierhülle herausragende Litze 406 ist mit einem Kabelschuh 412 elektrisch verbunden; im Ausführungsbeispiel besteht eine Crimpverbindung (zum Beispiel eine Quetschverbindung) zwischen der Litze 406 und dem Kabelschuh 412.

Es hat sich herausgestellt, dass im Fehlerfall an der aus der Isolierhülle 404 herausragenden Litze 406 (und insbesondere an den freien Enden 414 der Litze 406) Plasma entstehen kann. Dieses Plasma entsteht beispielsweise dadurch, dass durch die hohen Ströme das Kupfer der Litze aufgeschmolzen und verdampft wird (oder flüssiges Kupfer verspritzt wird). Daher ist die aus der Isolierhülle herausragende Litze 406 mit einer Kapselung 420 versehen. Diese Kapselung 420 besteht im Ausführungsbeispiel aus einem elektrisch isolierenden Vergussmaterial, beispielsweise aus einem Gießharz (wie zum Beispiel ein Epoxidharz, ein Polyesterharz oder ein Polyurethanharz). Das Gießharz kann faserverstärkt sein. Als Kapselungsmaterial bzw. Kapselungsgehäuse kann zum Beispiel Menzolit SMC 0290 verwendet werden. Dabei handelt es sich um einen handelsüblichen Kunststoff auf der Basis von glasfaserverstärktem ungesättigtem Polyesterharz.

Die Kapselung 420 kann im Ausführungsbeispiel auch aus einem elektrisch isolierenden Spritzmaterial bestehen, beispielsweise aus einem faserverstärkten Kunststoff. Als Spritzmaterial kann beispielsweise ein Thermoplast oder ein Duroplast verwendet werden, das mit Glasfasern oder mit Aramidfasern versehen ist. Die vorstehend genannten Materialien können bei allen in den Ausführungsbeispielen angegebenen Kapselungen eingesetzt werden. Das Kapselungsmaterial ist also ein elektrisch isolierendes Vergussmaterial oder ein elektrisch isolierendes Spritzmaterial. Da Kapselungsmaterial ist im Allgemeinen ein Kunststoff, insbesondere ein elektrisch isolierender Kunststoff.

Die Kapselung 420 behindert die Ausbreitung des Plasmas, das an der aus der Isolierhülle 404 herausragenden Litze 406 entstehen kann. Die Kapselung kann auch die Entstehung des Plasmas behindern oder sogar verhindern. Dadurch werden die zu dem betroffenen Modul benachbarten Module wirkungsvoll vor dem Plasma geschützt. Die Litzenleitung 402 ist also aufgrund der gekapselten Kabelenden eine kurzschlussfeste konfektionierte Leitung 402 (weil auch bei hohen Kurzschlussströmen die Ausbreitung von Plasma behindert wird). Das Kapselungsmaterial der Kapselung 420 kann beispielsweise durch Gießen mit dem genannten Vergussmaterial oder durch Spritzen mit dem genannten Spritzmaterial an der (aus der Isolierhülle 404 herausragenden) Litze 406 angebracht werden. Zusätzlich isoliert die Kapselung die aus der Isolierhülle 404 herausragende Litze 406 elektrisch. Das Kapselungsmaterial der Kapselung 420 liegt im Ausführungsbeispiel dicht an der Crimpverbindung des Kabelschuhs 412 und an der aus der Isolierhülle 404 herausragenden Litze 406 an. Vorzugsweise bestehen keine Hohlräume zwischen dem Kapselungsmaterial 420 und der Crimpverbindung des Kabelschuhs 412 oder der aus der Isolierhülle 404 herausragenden Litze 406 (hohlraumfreie Kapselung).

In Figur 5 ist in einer teilweisen Schnittdarstellung ein weiteres Ausführungsbeispiel einer Litzenleitung 502 dargestellt. Dieses Ausführungsbeispiel unterscheidet sich vom Ausführungsbeispiel der Figur 4 durch die Art der Kapselung. Zur Kapselung der aus der Isolierhülle 404 herausragenden Litze 406 dient im Ausführungsbeispiel der Figur 5 ein Kapselungsgehäuse 520. Dieses Kapselungsgehäuse 520 umschließt die aus der Isolierhülle 404 herausragende Litze 406. Dabei umschließt das Kapselungsgehäuse520 die Litze 406 derart, dass sich die herausragende Litze 406 in einem Innenraum 524 des Kapselungsgehäuses 520 befindet. Das Kapselungsgehäuse 520 kann beispielsweise mehrteilig ausgestaltet sein. Das Kapselungsgehäuse 520 kann beispielsweise nach dem elektrischen Verbinden der Litze 406 mit dem Kabelschuh 412 um die herausragende Litze 406 herum angeordnet werden. Dies kann ähnlich erfolgen zu der Art und Weise, wie zweiteilige Ferritkerne (sogenannter Klapp-Ferrit) um ein elektrisches Kabel herum angeordnet sind, um über dieses Kabel übertragene Störungen zu dämpfen. Das Kapselungsgehäuse 520 kann also aus zwei Gehäuseteilen bestehen, beispielsweise aus zwei Kunststoff-Gehäuseteilen. Die beiden Gehäuseteile sind um das aus der Isolierhülle 404 herausragende Ende der Litze 406 herum angeordnet und verspannt.

In Figur 6 ist ein weiteres Ausführungsbeispiel einer Litzenleitung 602 dargestellt. Das aus der Isolierhülle 404 herausragende Ende der Litze 406 ist mit einem Kapselungsgehäuse 620 gekapselt. Im Unterschied zum Ausführungsbeispiel der Figur 5 befinden sich in dem Kapselungsgehäuse zusätzlich zu der aus der Isolierhülle herausragenden Litze 406 auch die beiden elektronischen Schaltelemente 202 und 206 des Moduls (sowie gegebenenfalls die elektronischen Schaltelemente 302 und 306). Die Litzenleitung 602 ist jedoch elektrisch nicht unmittelbar mit den elektronischen Schaltelementen 202 und 206 verbunden. Vielmehr ist die Litzenleitung 602 mittels einer Schraube 622 mit einer Leiterplatte 624 elektrisch verbunden. Mittels der Leiterplatte 624 werden die über die Litzenleitung 602 übertragenden Signale (beispielsweise die Messsignale des Spannungssensors 250) weitergeleitet, beispielsweise zu der Modul-Steuereinrichtung 220.

Auch in diesem Ausführungsbeispiel behindert das Kapselungsgehäuse 620 die Ausbreitung von Plasma, das im Fehlerfall an der aus der Isolierhülle 404 herausragenden Litze 406 entsteht.

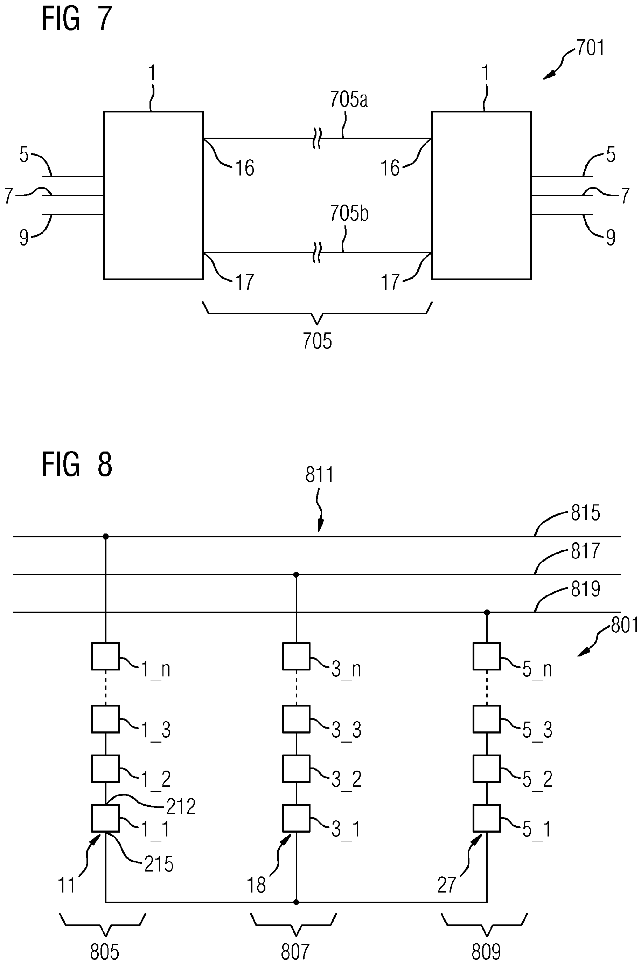

In Figur 7 ist schematisch ein Ausführungsbeispiel einer Hochspannungs-Gleichstrom-Übertragungsanlage 701 dargestellt. Diese Hochspannungs-Gleichstrom-Übertragungsanlage 701 weist zwei Stromrichter 1 auf, wie sie in Figur 1 dargestellt sind. Diese beiden Stromrichter 1 sind gleichspannungsseitig über eine Hochspannungs-Gleichstrom-Verbindung 705 elektrisch miteinander verbunden. Dabei sind die beiden positiven Gleichspannungsanschlüsse 16 der Stromrichter 1 mittels einer ersten Hochspannungs-Gleichstrom-Leitung 705a elektrisch miteinander verbunden; die beiden negativen Gleichspannungsanschlüsse 17 der beiden Stromrichter 1 sind mittels einer zweiten Hochspannungs-Gleichstrom-Leitung 705b elektrisch miteinander verbunden. Mittels einer derartigen Hochspannungs-Gleichstrom-Übertragungsanlage 701 kann elektrische Energie über weite Entfernungen übertragen werden; die Hochspannungs-Gleichstrom-Verbindung 705 weist dann eine entsprechende Länge auf.

In Figur 8 ist ein Ausführungsbeispiel eines Stromrichters 801 dargestellt, welcher als ein Blindleistungskompensator 801 dient. Dieser Stromrichter 801 weist lediglich die drei Phasenmodulzweige 11, 18 und 27 auf, welche drei Phasenmodule 805, 807 und 809 des Stromrichters bilden. Die Anzahl der Phasenmodule 805, 807 und 809 entspricht der Anzahl der Phasen eines Wechselspannungsnetzes 811, an das der Stromrichter 801 angeschlossen ist.

Die drei Phasenmodulzweige 11, 18 und 27 sind sternförmig miteinander verbunden. Das dem Sternpunkt entgegengesetzte Ende der drei Phasenmodulzweige ist mit jeweils einer Phasenleitung 815, 817 und 819 des dreiphasigen Wechselspannungsnetzes 811 elektrisch verbunden. (Die drei Phasenmodule 805, 807 und 809 können in einem anderen Ausführungsbeispiel anstelle in Sternschaltung auch in Dreieckschaltung geschaltet sein.) Der Stromrichter 801 kann das Wechselspannungsnetz 811 mit Blindleistung versorgen oder Blindleistung aus dem Wechselspannungsnetz 811 entnehmen.

Es wurde ein Modul eines modularen Multilevel-Umrichters beschrieben, bei dem die an einem Ende einer Litzenleitung aus der Isolierhülle herausragende Litze mit einer Kapselung versehen ist. Durch diese Kapselung ist das offene Leitungsende bzw. das offene Kabelende eingekapselt, so dass eine unkontrollierte Plasmaausbreitung am offenen Leitungsende reduziert oder vollständig verhindert wird. Somit wird das Risiko verringert, dass ein örtlich benachbartes Modul durch das Plasma beschädigt wird und ebenfalls ausfällt. Die Ausbreitung von im Fehlerfall entstehenden heißen Gasen (Plasma) wird also behindert; dadurch werden benachbarte Module vor Beschädigung geschützt.

## Patentansprüche

1. Modul (201) eines modularen Multilevelstromrichters (1), das mindestens zwei elektronische Schaltelemente (202, 206), einen elektrischen Energiespeicher (210) und eine elektrische Litzenleitung (252) aufweist,
**dadurch gekennzeichnet, dass**
die Litzenleitung (252) eine metallische Litze und eine die Litze umgebende Isolierhülle (404) aufweist, und wobei aus der Isolierhülle (404) herausragende Litze (406) mit einer Kapselung (420) versehen ist.

2. Modul nach Anspruch 1,
**dadurch gekennzeichnet, dass**
- die Kapselung eine elektrisch isolierende Kapselung (420) ist.

3. Modul nach Anspruch 1 oder 2,
**dadurch gekennzeichnet, dass**
- die Kapselung (420) die herausragende Litze (406) umhüllt.

4. Modul nach einem der vorhergehenden Ansprüche,
**dadurch gekennzeichnet, dass**
- die Kapselung ein die herausragende Litze (406) umgebendes Kapselungsgehäuse (520) oder ein die herausragende Litze umgebendes Kapselungsmaterial (420) aufweist.

5. Modul nach Anspruch 4,
**dadurch gekennzeichnet, dass**
- das Kapselungsmaterial ein elektrisch isolierendes Vergussmaterial (420) oder ein elektrisch isolierendes Spritzmaterial (420) ist.

6. Modul nach Anspruch 4,
**dadurch gekennzeichnet, dass**
- das Kapselungsgehäuse (620) die herausragende Litze (406) und die zwei elektronischen Schaltelemente (202, 206) einkapselt.

7. Modul nach einem der vorhergehenden Ansprüche,
**dadurch gekennzeichnet, dass**
- die Litzenleitung (252) verbunden ist mit einem Spannungssensor (250) zum Ermitteln der Spannung des Energiespeichers (210).

8. Modul nach einem der vorhergehenden Ansprüche,
**dadurch gekennzeichnet, dass**
- die Litzenleitung (252) einen Spannungssensor (250) zum Ermitteln der Spannung des Energiespeichers (210) mit einer Steuereinrichtung (220) des Moduls verbindet.

9. Modul nach einem der vorhergehenden Ansprüche,
**dadurch gekennzeichnet, dass**
- der elektrische Energiespeicher ein Kondensator (210) ist.

10. Modul nach einem der vorhergehenden Ansprüche,
**dadurch gekennzeichnet, dass**
- die zwei elektronischen Schaltelemente (202, 206) des Moduls (201) in einer Halbbrückenschaltung angeordnet sind.

11. Modul nach einem der vorhergehenden Ansprüche,
**dadurch gekennzeichnet, dass**
- das Modul (301) die zwei elektronischen Schaltelemente (202, 206) und zwei weitere elektronische Schaltelemente (302, 306) aufweist, wobei die zwei elektronischen Schaltelemente (202, 206) und die zwei weiteren elektronischen Schaltelemente (302, 306) in einer Vollbrückenschaltung angeordnet sind.

12. Modularer Multilevelstromrichter (1) mit mindestens einem Modul (1_1), insbesondere mit einer Mehrzahl von Modulen (1_1 ... 6_n), nach einem der Ansprüche 1 bis 11.

13. Hochspannungs-Gleichstrom-Übertragungsanlage (701) mit einem modularen Multilevelstromrichter (1) nach Anspruch 12.

14. Blindleistungs-Kompensationsanlage (801) mit einem modularen Multilevelstromrichter (1) nach Anspruch 12.

## Claims

1. Module (201) of a modular multilevel converter (1) that has at least two electronic switching elements (202, 206), an electrical energy store (210) and an electrical braided line (252),
**characterized in that**
the braided line (252) has a metallic braid and an insulating covering (404) surrounding the braid, and wherein braid (406) protruding from the insulating covering (404) is provided with an encapsulation (420).

2. Module according to Claim 1,
**characterized in that**
- the encapsulation is an electrically insulating encapsulation (420).

3. Module according to Claim 1 or 2,
**characterized in that**
- the encapsulation (420) covers the protruding braid (406).

4. Module according to one of the preceding claims, **characterized in that**
- the encapsulation has an encapsulation housing (520) surrounding the protruding braid (406) or an encapsulation material (420) surrounding the protruding braid.

5. Module according to Claim 4,
**characterized in that**
- the encapsulation material is an electrically insulating casting material (420) or an electrically insulating injection material (420) .

6. Module according to Claim 4,
**characterized in that**
- the encapsulation housing (620) encapsulates the protruding braid (406) and the two electronic switching elements (202, 206) .

7. Module according to one of the preceding claims,
**characterized in that**
- the braided line (252) is connected to a voltage sensor (250) for determining the voltage of the energy store (210).

8. Module according to one of the preceding claims,
**characterized in that**
- the braided line (252) connects a voltage sensor (250) for determining the voltage of the energy store (210) to a control device (220) of the module.

9. Module according to one of the preceding claims,
**characterized in that**
- the electrical energy store is a capacitor (210).

10. Module according to one of the preceding claims,
**characterized in that**
- the two electronic switching elements (202, 206) of the module (201) are arranged in a half-bridge circuit.

11. Module according to one of the preceding claims,
**characterized in that**
- the module (301) has the two electronic switching elements (202, 206) and two further electronic switching elements (302, 306), wherein the two electronic switching elements (202, 206) and the two further electronic switching elements (302, 306) are arranged in a full-bridge circuit.

12. Modular multilevel converter (1) having at least one module (1 1), in particular having a plurality of modules (1_1 ... 6_n), according to one of Claims 1 to 11.

13. High-voltage DC transmission installation (701) having a modular multilevel converter (1) according to Claim 12.

14. Power factor correction installation (801) having a modular multilevel converter (1) according to Claim 12.

## Revendications

1. Module (201) d'un convertisseur (1) modulaire à plusieurs niveaux, qui a au moins deux éléments (202, 206) électroniques de coupure, un accumulateur (210) d'énergie électrique et un conducteur (252) électrique toronné,
**caractérisé en ce que**
le conducteur (252) toronné a un toron métallique et une gaine (404) isolante entourant le toron et dans lequel le toron (406) sortant de la gaine (404) isolante est pourvu d'un blindage (420) .

2. Module suivant la revendication 1,
**caractérisé en ce que**
- le blindage est un blindage (420) isolant du point de vue électrique.

3. Module suivant la revendication 1 ou 2,
**caractérisé en ce que**
- le blindage (420) gaine le toron (406) qui sort.

4. Module suivant l'une des revendications précédentes, **caractérisé en ce que**
- le blindage a un boîtier (520) de blindage entourant le toron (406) qui sort ou un matériau (420) de blindage entourant le toron qui sort.

5. Module suivant la revendication 4,
**caractérisé en ce que**
- le matériau de blindage est un matériau (420) de coulée isolant du point de vue électrique ou un matériau (420) d'injection isolant du point de vue électrique.

6. Module suivant la revendication 4,
**caractérisé en ce que**
le boîtier (620) de blindage blinde le toron (406) qui sort et les deux éléments (202, 206) électroniques de coupure.

7. Module suivant l'une des revendications précédentes,
**caractérisé en ce que**
- le conducteur (252) toronné est relié à un capteur (250) de tension pour la détermination de la tension de l'accumulateur (210) d'énergie.

8. Module suivant l'une des revendications précédentes,
**caractérisé en ce que**
- le conducteur (252) toronné relie un capteur (250) de tension pour la détermination de la tension de l'accumulateur (210) d'énergie à un dispositif (220) de commande du module.

9. Module suivant l'une des revendications précédentes,
**caractérisé en ce que**
- l'accumulateur d'énergie électrique est un condensateur (210) .

10. Module suivant l'une des revendications précédentes,
**caractérisé en ce que**
- les deux éléments (202, 206) électroniques de coupure du module (201) sont montés en un circuit à demi-pont.

11. Module suivant l'une des revendications précédentes,
**caractérisé en ce que**
- le module (301) a les deux éléments (202, 206) électronique de coupure et deux autres éléments (302, 306) électroniques de coupure, les deux éléments (202, 206) électroniques de coupure et les deux autres éléments (302, 306) électroniques de coupure étant montés en un circuit à pont complet.

12. Convertisseur (1) modulaire à plusieurs niveaux ayant au moins un module (1_1), notamment une pluralité de modules (1_1...6_n) suivant l'une des revendications 1 à 11.

13. Installation (701) de transport de courant continu à haute tension comprenant un convertisseur (1) modulaire à plusieurs niveaux suivant la revendication 12.

14. Installation (801) de compensation de puissance réactive ayant un convertisseur (1) modulaire à plusieurs niveaux suivant la revendication 12.
